# DEMANDE DE BREVET EUROPEEN

(11) **EP 1 103 979 A1**
(43) Date de publication de la demande: **30.05.2001**
(21) Numéro de dépôt: 00403185.2
(22) Date de dépôt: 16.11.2000
(51) Int. Cl.: G11C 11/409, G11C 7/10, G11C 7/06, G11C 11/412

(54) **Dispositif de mémoire vive dynamique, et procédé de lecture correspondant**

(30) Priorité: 24.11.1999 FR 9914792
(71) Demandeur: STMicroelectronics SA, 94250 Gentilly Cedex (FR)
(72) Inventeur: Ferrant, Richard, 38190 Crolles (FR)
(74) Mandataire: Dossmann, Gérard

(57) **Abrégé**

Le dispositif de mémoire vive dynamique comprend un plan mémoire comportant au moins une première matrice de cellules-mémoire CM, un amplificateur de lecture/écriture AMLE connecté à l'extrémité de chaque colonne de la matrice et au moins une paire de lignes d'entrée/sortie IO, ION associée à la matrice. Il comprend en outre au moins un étage de mémoire-cache MCH connecté à chaque amplificateur et disposé au voisinage immédiat de cet amplificateur, cet étage de mémoire-cache comportant une cellule de mémoire vive statique connectée entre l'amplificateur de lecture/écriture AMLE et la paire de lignes d'entrée/sortie IO, ION.

## Description

L'invention concerne les mémoires vives dynamiques (DRAM : Dynamic Random Access Memory, en langue anglaise) encore dénommées "Mémoires dynamiques à accès aléatoire", et plus particulièrement leur lecture.

Par opposition aux mémoires statiques classiques à accès aléatoire (SRAM) ou mémoires vives statiques, dans lesquelles l'information stockée le reste indéfiniment au moins tant que ces mémoires restent alimentées, les mémoires dynamiques ont la particularité de requérir des rafraîchissements périodiques de l'information stockée.

Par ailleurs, la lecture d'une donnée binaire mémorisée dans une cellule de mémoire vive dynamique est destructrice. Par conséquent, si l'on souhaite conserver ladite donnée dans la cellule-mémoire dynamique après sa lecture, il est nécessaire de la réécrire après cette lecture.

Classiquement, une mémoire vive dynamique comporte un plan-mémoire organisé de façon matricielle en lignes et en colonnes de cellules-mémoire. Un amplificateur de lecture/écriture est connecté à l'extrémité de chaque colonne de la matrice et une paire de lignes d'entrée/sortie ("I/O lines" en langue anglaise) est connecté à chaque amplificateur de lecture/écriture.

Par ailleurs, chaque colonne de la matrice comporte deux lignes de bits ("bit lines", en langue anglaise) sur l'une au moins desquelles sont connectées toutes les cellules-mémoire de la colonne, (notamment lorsqu'il s'agit de cellules-mémoire à un transistor) l'autre ligne de bits servant de référence.

Lorsqu'on veut lire une donnée mémorisée dans une cellule-mémoire du plan-mémoire, on précharge les lignes de bits de la colonne considérée à une tension prédéterminée commune, par exemple Vdd/2 où Vdd désigne la tension d'alimentation du circuit intégré. On sélectionne alors la ligne de cellules-mémoire dans laquelle se situe la cellule-mémoire à lire. Si, par exemple, la donnée mémorisée était un "1" logique, la ligne de bits connectée à la cellule voit alors sa tension augmenter par rapport à la tension de la ligne de bits de référence.

On sélectionne alors l'amplificateur de lecture/écriture, le noeud de cet amplificateur connecté à la ligne de bits monte alors à la tension Vdd, tandis que le noeud de l'amplificateur relié à la ligne de bits de référence descend à la masse. Ceci a par conséquent pour effet de réécrire la donnée dans la cellule-mémoire.

Pour délivrer cette donnée à l'extérieur de la mémoire, on active alors la paire de lignes d'entrée-sortie, c'est-à-dire que l'on rend passants les transistors reliant cette paire de lignes d'entrée-sortie aux deux noeuds précédemment mentionnés de l'amplificateur de lecture/écriture. La différence de tension entre les deux lignes d'entrée/sortie est alors égale à la tension d'alimentation Vdd en valeur absolue. Le signe de cette différence de tension détermine la valeur logique de l'information lue.

Cependant, en raison de la différence de potentiel importante (Vdd) existant entre les deux lignes d'entrée-sortie lors de la lecture d'une donnée, et en raison également du fait que ces lignes d'entrée-sortie sont relativement longues et par conséquent relativement dortement capacitives, il se produit lors de la lecture de la donnée, un pic de courant non négligeable qui est pénalisant du point de vue consommation.

L'invention vise à résoudre ce problème.

Un but de l'invention est de proposer une architecture de mémoire vive dynamique, présentant une consommation moindre de courant lors de la lecture.

L'invention a également pour but d'augmenter le débit d'information échangé entre la mémoire et d'autres composants (par exemple un microprocesseur, connecté à l'extérieur de cette mémoire).

L'invention propose donc de connecter à chaque amplificateur de lecture-écriture une cellule de mémoire-cache, de disposer cette cellule de mémoire-cache au voisinage immédiat de l'amplificateur de lecture/écriture, et de relier cette cellule de mémoire-cache à une paire de lignes d'entrée/sortie. Le fait de disposer cette cellule de mémoire-cache au voisinage de l'amplificateur permet, lors du transfert de la donnée dans la cellule de mémoire-cache via l'amplificateur, de n'avoir une différence de potentiel importante (Vdd par exemple) que sur une connexion métallique courte donc très peu capacitive, et donc de limiter le courant.

Par ailleurs, cette cellule de mémoire-cache est une cellule de mémoire vive statique dont on peut lire le contenu en n'utilisant qu'un faible pourcentage de la tension d'alimentation (Vdd) du dispositif. Le caractère fortement capacitif des lignes d'entrée/sortie est donc compensé ici par la faible différence de tension nécessaire pour la lecture de la donnée contenue dans la cellule de mémoire-cache.

En d'autres termes l'invention propose un dispositif de mémoire vive dynamique, comprenant un plan mémoire comportant au moins une première matrice de cellules-mémoire, un amplificateur de lecture/écriture connecté à l'extrémité de chaque colonne de la matrice et au moins une paire de lignes d'entrée/sortie associée à la matrice. Selon une caractéristique générale de l'invention, le dispositif comprend en outre au moins un étage de mémoire-cache connecté à chaque amplificateur et disposé au voisinage immédiat de cet amplificateur, cet étage de mémoire-cache comportant une cellule de mémoire vive statique connectée entre l'amplificateur de lecture/écriture et la paire de lignes d'entrée/sortie.

Cependant, le fait de disposer une cellule de mémoire statique, voire plusieurs en parallèle, au voisinage immédiat de chaque amplificateur de lecture/écriture, nécessite, dans certaines architectures dans lesquelles la place disponible pour disposer la cellule SRAM est faible, l'utilisation d'une cellule de mémoire statique particulièrement compacte avec un nombre relativement réduit de transistors. Or les cellules de mémoire statique classiques comprennent généralement une bonne dizaines de transistors dont quatre transistors de mémorisation, et trois transistors de précharge. Il s'avère alors impossible de placer une telle cellule de mémoire statique lorsque l'encombrement disponible au pied d'un amplificateur de lecture/écriture est faible.

Aussi, l'invention prévoit-elle avantageusement en combinaison, d'utiliser, en tant que cellule de mémoire-cache, une cellule de mémoire vive statique comportant un très faible nombre de transistors, et en particulier deux transistors de mémorisation. Mais, avec une telle cellule de mémoire statique particulièrement compacte, il existe un risque de perte de la donnée mémorisée dans cette cellule en raison notamment des courants de fuite inhérents à tout transistor. C'est pourquoi, il est alors nécessaire que l'étage de mémoire-cache selon l'invention contienne également des moyens de rétention aptes à maintenir dans la cellule de mémoire statique une donnée binaire y ayant été préalablement transférée depuis une cellule-mémoire du plan-mémoire via l'amplificateur.

En d'autres termes, l'invention propose d'utiliser dans un mode de réalisation, un étage de mémoire-cache comportant une cellule de mémoire vive statique possédant deux transistors de mémorisation, une paire de premiers transistors d'accès connectés entre l'amplificateur et les transistors de mémorisation, une paire de deuxièmes transistors d'accès respectivement connectés entre la paire de lignes d'entrée/sortie et les transistors de mémorisation, et des moyens de rétention aptes à maintenir dans ladite cellule de mémoire statique une donnée binaire y ayant été préalablement transférée depuis une cellule-mémoire via l'amplificateur.

Dans un mode de réalisation, il est prévu que les deuxièmes transistors d'accès aient des courants de fuite plus importants que les autres transistors de la cellule de mémoire statique. Les moyens de rétention comportent alors les deuxièmes transistors d'accès. Ce mode de réalisation est alors particulièrement compact.

Plusieurs possibilités sont offertes pour obtenir des courants de fuite plus importants dans certains transistors que dans d'autres. Parmi ces possibilités, celles qui vont être évoquées maintenant peuvent être utilisées seules ou en combinaison.

Plus précisément, une première possibilité réside dans un aspect technologique et consiste pour les transistors dont on souhaite qu'ils présentent les courants de fuite les plus importants, de prévoir une longueur de canal et une épaisseur d'oxyde de grille plus petites que la longueur de canal et l'épaisseur d'oxyde de grille des autres transistors de la cellule de mémoire statique.

En variante, les moyens de rétention peuvent comporter des moyens aptes à appliquer des tensions de polarisation prédéterminées différentes en certaines des bornes de chaque transistor pour lesquelles on souhaite obtenir un courant de fuite plus important. En d'autres termes, on agit ici directement sur les transistors dont on souhaite qu'ils présentent un courant de fuite plus important, en augmentant leur courant de fuite par application de tensions de polarisation prédéterminées différentes en certaines des bornes de ces transistors.

Une autre possibilité pour la réalisation des moyens de rétention, consiste à prévoir des moyens aptes à appliquer un effet substrat sur chaque transistor de la cellule de mémoire statique, à l'exception de ceux dont on souhaite qu'ils présentent un courant de fuite plus important. Ainsi, on obtient cette caractéristique en diminuant les courants de fuite des autres transistors de la cellule de mémoire statique par application d'un effet substrat sur ces autres transistors, c'est-à-dire par une application de tensions de polarisation prédéterminées différentes sur le substrat et la source de ces transistors.

Afin d'augmenter le débit du dispositif de mémoire vive dynamique selon l'invention, il est avantageusement prévu qu'au moins deux étages de mémoire-cache soient respectivement connectés en parallèle à chaque amplificateur. Ainsi, par exemple, pendant qu'on lit une donnée contenue dans un étage de mémoire-cache, on peut transférer une donnée d'une cellule-mémoire du plan-mémoire dans l'autre étage de mémoire-cache.

L'invention a également pour objet un procédé de lecture d'une donnée mémorisée dans une cellule-mémoire du plan mémoire du dispositif de mémoire tel que défini précédemment, procédé dans lequel on transfert la donnée dans la cellule de mémoire vive statique de l'étage de mémoire cache associé à la colonne contenant ladite cellule-mémoire, puis on lit le contenu de la cellule de mémoire statique par l'intermédiaire des lignes d'entrée/sortie.

D'autres avantages et caractéristiques de l'invention apparaîtront à l'examen de la description détaillée de modes de réalisation, nullement limitatifs, et des dessins annexés, sur lesquels:
- la figure 1 illustre de façon schématique un amplificateur de lecture-écriture connecté au bas d'une colonne du plan-mémoire;
- la figure 2 illustre schématiquement une première variante de réalisation d'un étage de mémoire-cache selon l'invention, connecté à l'amplificateur de lecture-écriture de la figure 1;
- les figures 3 à 7 illustrent schématiquement différentes possibilités permettant la réalisation des moyens de rétention d'une donnée transférée temporairement dans un étage de mémoire-cache;
- la figure 8 illustre schématiquement un mode de réalisation d'une architecture globale d'une mémoire vive dynamique selon l'invention; et
- la figure 9 illustre schématiquement une autre variante de réalisation d'un étage de mémoire-cache, selon l'invention.

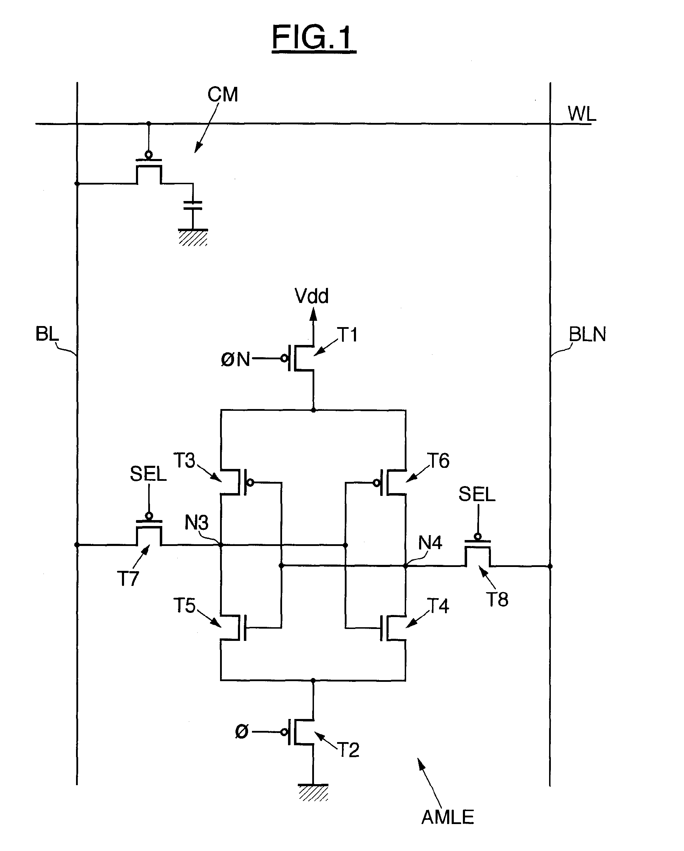

Sur la figure 1, les références BL et BLN désignent deux lignes de bits appartenant à une colonne d'une matrice de cellules-mémoire du plan-mémoire du dispositif selon l'invention.

Dans l'exemple qui est décrit ici, on a représenté très schématiquement chaque cellule-mémoire du plan-mémoire par une capacité de stockage et un transistor d'accès. Bien entendu, l'invention s'applique à tous types de cellules-mémoire dynamiques, composés de un ou plusieurs transistors. La cellule-mémoire est ici connectée par l'intermédiaire du transistor d'accès sur l'une des lignes de bits, à savoir la ligne de bits BL. Dans d'autres modes de réalisation, il est également possible que la cellule-mémoire soit connectée entre les deux lignes de bits. Le transistor d'accès est commandé par une ligne de mots WL ("Word line", en langue anglaise).

Au bas de la colonne, est disposé un amplificateur de lecture/écriture AMLE dont une structure classique et connue en soi est représentée schématiquement sur cette figure 1. Plus précisément, cet amplificateur AMLE se compose d'un double inverseur formé de deux transistors PMOS (transistors à effet de champ à grille isolée à canal P) T3 et T6, et de deux transistors NMOS (transistors à canal N) T4 et T5. Le noeud commun N4 aux deux transistors T4 et T6, est connecté aux grilles des transistors T3 et T5, tandis que le noeud commun N3 aux deux transistors T3 et T5 est connecté aux grilles des transistors T4 et T6. La borne commune des deux transistors T3 et T6 est reliée à la tension d'alimentation Vdd par l'intermédiaire d'un transistor PMOS référencé T1. La borne commune des deux transistors T5 et T4 est reliée à la masse par l'intermédiaire d'un transistor NMOS référencé T2. Ces deux transistors T2 et T1 sont commandés par deux signaux logiques complémentaires, respectivement référencés Ø et ØN.

Les noeuds N3 et N4 de l'amplificateur AMLE sont respectivement connectés aux lignes de bits BL et BLN par l'intermédiaire de deux transistors NMOS T7 et T8 commandés par un signal logique SEL.

Le fonctionnement d'un tel amplificateur est également classique et connu en soi. On en rappelle cependant ici les principes essentiels.

On suppose à titre d'exemple qu'une valeur logique "1" est mémorisée dans la cellule-mémoire CM.

Pour lire la donnée CM, on précharge tout d'abord la ligne de bits BL et la ligne de bits de référence BLN à une même tension, par exemple la tension Vdd/2. On sélectionne ensuite la rangée contenant la cellule CM à l'aide du signal WL (à des fins de simplification, on a représenté par la même référence la ligne de mots WL et le signal logique activant cette ligne de mots). Ceci a pour effet de rendre passant le transistor d'accès de la cellule CM. La tension sur la ligne de bits BL est alors égale à Vdd/2 + AV, tandis que la tension sur la ligne de bits BLN reste égale à Vdd/2.

On rend passants les transistors T7 et T8, puis on rend passants les transistors Tl et T2. La tension au noeud N3, initialement égale à Vdd/2 + ΔV monte alors jusqu'à Vdd, tandis que la tension au noeud N4, initialement égale à Vdd/2 descend jusqu'à 0.

La montée de la tension du noeud N3 jusqu'à Vdd a pour effet de rétablir le niveau de tension aux bornes de la capacité de la cellule-mémoire CM, et par conséquent de réécrire dans cette cellule CM la donnée qui vient d'être lue.

Dans l'art antérieur, il était prévu deux transistors respectivement connectés entre les noeuds N3 et N4 de l'amplificateur de lecture/écriture AMLE et deux lignes d'entrée/sortie. La lecture de la donnée en sortie de la mémoire s'effectuait alors en rendant passants ces deux transistors. La différence de potentiel entre les deux lignes d'entrée/sortie était égale alors à Vdd. Le signe de cette différence permettait d'en déduire le contenu logique "0" ou "1" de la donnée lue.

Généralement, dans une mémoire vive dynamique, les lignes d'entrée/sortie sont relativement longues et présentent un caractère fortement capacitif, avec une capacité généralement de l'ordre de 500 fF. Et, le produit de cette capacité par la différence de tension entre les deux lignes d'entrée/sortie, en l'espèce la tension d'alimentation nominale Vdd du circuit intégré, conduit à un pic de courant important lors de la lecture.

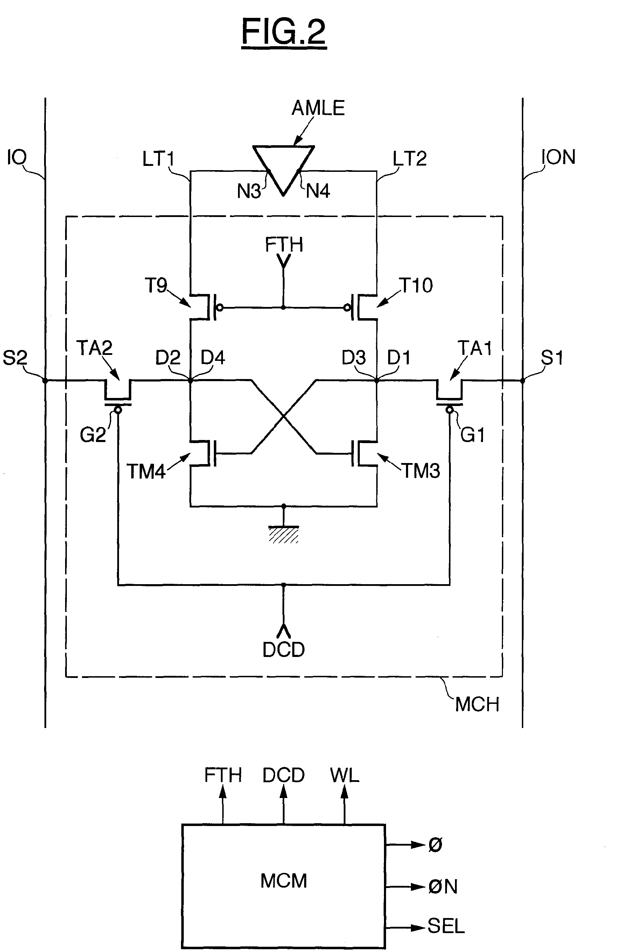

L'invention résout ce problème en connectant entre l'amplificateur de lecture/écriture AMLE et la paire de lignes d'entrée/sortie, un étage de mémoire-cache MCH, tel qu'illustré sur la figure 2, et comportant une cellule de mémoire vive statique à deux transistors de mémorisation TM3 et TM4.

Sur la figure 2, on a représenté schématiquement par un triangle l'amplificateur AMLE et l'on a simplement fait figurer les noeuds N3 et N4.

La cellule de mémoire statique formant l'étage de mémoire-cache MCH comporte deux premiers transistors d'accès PMOS référencés T9 et T10, commandés sur leurs grilles par un signal de commande FTH. La source du transistor T9 est reliée au noeud N3 par une métallisation LT1 très courte, tandis que la source du transistor T10 est reliée au noeud N4 par une métallisation LT2 très courte. Le drain du transistor T9 est relié au drain D4 du transistor de mémorisation TM4, tandis que le drain du transistor T10 est relié au drain D3 du transistor de mémorisation TM3. Les sources des deux transistors de mémorisation TM3 et TM4 sont reliées à la masse.

La grille du transistor TM4 est reliée au drain D3 du transistor TM3, tandis que la grille de l'autre transistor de mémorisation TM3 est reliée au drain du transistor TM4.

La cellule de mémoire statique comporte également un deuxième port d'accès composé ici des deuxièmes transistors d'accès TA1 et TA2. Les transistors TA1 et TA2 sont ici des transistors PMOS commandés sur leurs grilles G1, G2 par un signal logique DCD. Le drain D2 du transistor d'accès TA2 est relié au drain D4 du transistor de mémorisation TM4, tandis que le drain D1 du transistor d'accès TA1 est relié au drain D3 du transistor de mémorisation TM3. La source S2 du transistor TA2 est reliée à la ligne d'entrée/sortie IO, tandis que la source S1 du transistor d'accès TA1 est reliée à l'autre ligne d'entrée/sortie ION.

Les différents signaux logiques FTH, DCD, WL, Ø1, ØN et SEL sont délivrés par des moyens logique de commande MCM dont la structure est classique dans le domaine des mémoires et qui peuvent donc être aisément réalisés par l'homme du métier.

On va maintenant décrire plus en détail le fonctionnement de cette cellule de mémoire-cache MCH afin de montrer la nécessité d'équiper cette cellule de moyens de rétention de la donnée binaire qui y est transférée, moyens de rétention qui, comme on va le voir plus en détail ci-après, peuvent être obtenus de différentes façons, notamment de façon technologique, et qui ne sont pas représentés sur le schéma de la figure 2, à des fins de simplification.

On suppose maintenant que la donnée lue dans la cellule-mémoire CM du plan-mémoire était un " 1 " logique et que par conséquent après activation de l'amplificateur de lecture-écriture AMLE, la tension Vdd est présente au noeud N3, tandis qu'une tension nulle est présente au noeud N4.

Dans l'exemple de réalisation qui est décrit sur la figure 2, les deuxièmes transistors d'accès TA1 et TA2 présentent des courants de fuite plus importants que les courants de fuite de tous les autres transistors de la cellule de mémoire-cache. En d'autres termes, leur courant de fuite dans l'état bloqué, c'est-à-dire le courant drain-source dans l'état bloqué (courant I_{off}), est supérieur aux courants de fuite, c'est-à-dire aux courants drain-source I_{off} des autres transistors de la cellule de mémoire-cache dans leur état bloqué. Et, ces transistors d'accès TA1 et TA2, plus "fuiteux" vont contribuer à éviter une perte de la donnée transférée dans cette cellule de mémoire-cache MCH avant sa lecture via les lignes d'entrée-sortie IO et ION.

Avant le transfert de la donnée dans la cellule MCH, les lignes d'entrée-sortie IO et ION sont préchargées à une tension de mode commun identique, par exemple la tension Vdd. Avant le transfert, le signal logique FTH est à 1, bloquant les premiers transistors d'accès T9 et T10. Le signal logique DCD est également à 1, bloquant les deuxièmes transistors d'accès TA1 et TA2.

Pour effectuer le transfert, les moyens de commande MCM font passer à 0 le signal FTH, ce qui a pour effet de rendre passants les transistors T9 et T10. Les transistors TA1 et TA2 restent toujours bloqués. La tension au drain D4 monte alors à Vdd, ce qui rend passant le transistor de mémorisation TM3. Par ailleurs, la tension au drain D3 chute à 0, ce qui bloque le transistor de mémorisation TM4.

On bloque à nouveau les transistors T9 et T10 en conférant la valeur logique "1" au signal FTH. La donnée binaire est alors transférée dans la cellule de mémoire-cache, et y est mémorisée aux noeuds D4 et D1.

L'homme du métier remarque alors que si le transistor TM4, qui est bloqué, était plus fuiteux que le transistor T9, également bloqué, l'information binaire contenue dans la cellule de mémoire cache risquerait de disparaître puisque la tension au drain D4 aurait tendance à chuter vers 0 en raison du caractère fuiteux important du transistor de mémorisation TM4. (Bien entendu, le raisonnement qui a été explicité ici avec les transistors TM4 et T9, serait le même avec les transistors TM3 et T10 dans le cas où une valeur logique "0" avait été mémorisée dans la cellule-mémoire CH, ce qui conduirait alors à une tension égale à Vdd au noeud N4 et à une tension nulle au noeud N3).

Par ailleurs, si le transistor T9 était également relativement fuiteux, l'information binaire stockée dans la cellule-mémoire cache pourrait également disparaître dans le cas où le contenu de l'amplificateur de lecture/écriture AMLE changeait, c'est-à-dire dans le cas où on appliquait postérieurement au transfert de la donnée, une tension nulle au noeud N3 et une tension égale à Vdd au noeud N4. En effet, dans ce cas, la tension Vdd présente au drain D4 risquerait de chuter vers 0 en raison des fuites du transistor T9.

L'invention résout ce problème en rendant les transistors d'accès TA1 et TA2 plus fuiteux que les autres transistors de la cellule.

En effet, dans ce cas, puisque le transistor d'accès TA2 est plus fuiteux que les transistors T9 et TM4, la tension au drain D4 va être conditionnée par la tension à la source S2 du transistor TA2, c'est-à-dire la tension sur la ligne d'entrée-sortie IO. Or, puisque la tension sur la ligne d'entrée-sortie IO est égale à Vdd, et que le transistor TA2 est plus fuiteux que les transistors T9 et TM4, la tension au drain D4 reste égale à Vdd. (Bien entendu, le raisonnement qui vient d'être tenu ici pour le transistor TA2 et la ligne IO serait identique pour le transistor TA1 et la ligne ION dans le cas où ce serait cette fois-ci le drain D3 qui aurait une tension égale à Vdd).

Parallèlement, le transistor TM3 étant passant, la tension nulle présente au drain D3 reste nulle.

Lorsque l'on souhaite lire la donnée contenue dans la cellule de mémoire-cache MCH, on stoppe la précharge des lignes d'entrée/sortie IO et ION, celle-ci ayant alors un niveau de tension Vdd "capacitif" et non plus imposé par une source de tension. On confère la valeur logique "0" au signal DCD, ce qui rend passants les transistors d'accès TA1 et TA2. La tension de la ligne d'entrée/sortie IO reste égale à Vdd, tandis qu'il s'opère un transfert de charge de la ligne ION vers la masse via le transistor TA1 et le transistor TM3. Et, dès que la différence de tension entre les lignes IO et ION atteint un niveau suffisant, en l'espèce quelques dizaines de millivolts, ce qui correspond à quelques pourcents de la tension d'alimentation Vdd, les amplificateurs classiquement situés aux extrémités des lignes IO et ION sont capables de détecter cette différence de tension et l'on peut donc en déduire la valeur logique de la donnée binaire lue en fonction du signe de cette différence de tension.

Puisque cette lecture ne nécessite que quelques pourcents de la tension d'alimentation Vdd, le pic de courant lors de la lecture est considérablement diminué.

Par ailleurs, puisque la cellule de mémoire-cache est située au voisinage de l'amplificateur AMLE, les métallisations LT1 et LT2 reliant les noeuds N3 et N4 de l'amplificateur AMLE à la cellule de mémoire-cache, sont très courtes (leur longueur est de l'ordre de 1 à 2 microns). Par conséquent, même si lors du transfert de la donnée dans la cellule de mémoire-cache via l'amplificateur AMLE, la différence de tension entre les deux métallisations LT1 et LT2 est égale à Vdd, le courant consommé reste faible puisque la faible longueur de ces métallisations LT1 et LT2 conduit à des faibles capacités, typiquement de l'ordre de quelques fF (typiquement 5 fF).

A titre indicatif, l'écriture d'une donnée depuis l'extérieur de la mémoire dans la cellule de mémoire-cache s'effectue en forçant l'une des lignes d'entrée/sortie à la masse et l'autre à Vdd.

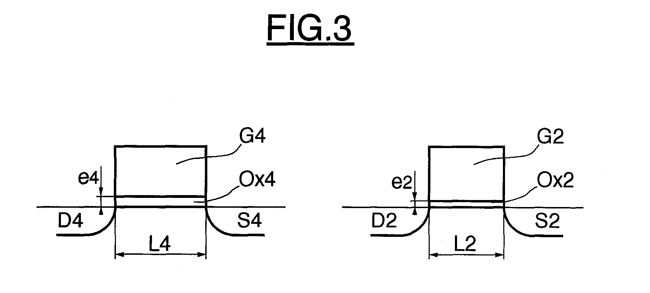

On va maintenant décrire en se référant plus particulièrement aux figures 3 à 7, différentes possibilités de rendre les deuxièmes transisors d'accès TA1 et TA2 plus fuiteux que les autres transistors de la cellule de mémoire-cache.

Un première solution (figure 3) est une solution technologique. Elle consiste à utiliser, en tant que deuxièmes transistors d'accès TA1 et TA2, des transistors dont l'épaisseur e2 de l'oxyde de grille Ox2 est plus faible que l'épaisseur e4 de l'oxyde de grille Ox4 des autres transistors de la cellule, en l'espèce les transistors T9, T10, TM4 et TM3. Par ailleurs, on choisira également pour les deuxièmes transistors d'accès TA1 et TA2, des transistors présentant une longueur de canal L2, c'est-à-dire une distance drain-source, plus faible que la longueur de canal L4 des autres transistors de la cellule. D'un point de vue pratique, on pourra par exemple réaliser les deuxièmes transistors d'accès avec une technologie 0,18 micron, ce qui conduit à une longueur L2 de l'ordre de 0,18 micron et une épaisseur e2 de l'ordre de 35 Å. Les autres transistors de la cellule de mémoire-cache seront quant à eux réalisés avec une technologie 0,35 micron, conduisant à une longueur de canal L4 de l'ordre de 0,35 micron et une épaisseur d'oxyde de grille e4 de l'ordre de 70 Å.

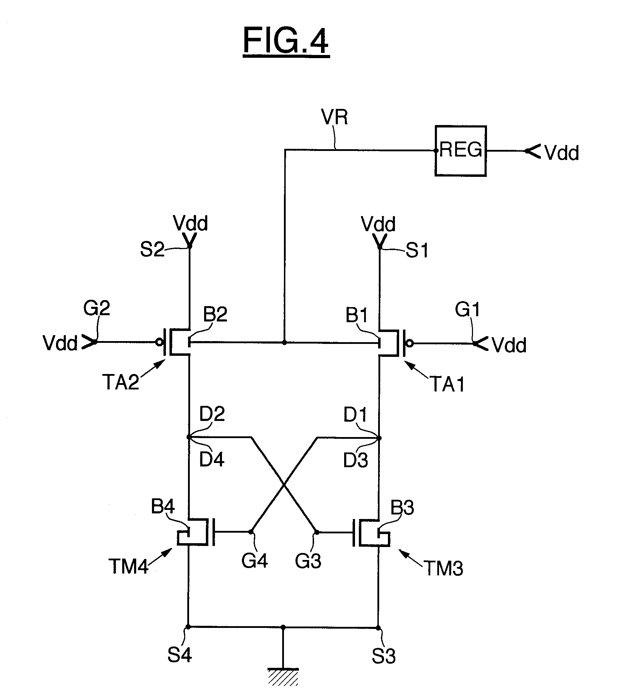

Une autre possibilité pour obtenir des transistors d'accès TA1 et TA2 plus fuiteux que les autres transistors de la cellule de la mémoire-cache MCH, est illustrée schématiquement sur la figure 4. Cette solution n'est d'ailleurs pas incompatible avec la solution technologique précédemment exposée et les deux solutions peuvent être éventuellement combinées.

Plus précisément, dans la variante illustrée sur la figure 4, les moyens de rétention comportent alors des moyens REG aptes à appliquer des tensions de polarisation prédéterminée différentes en certaines des bornes de chaque deuxième transistor d'accès TA2 et TA1, de façon à faire circuler dans chaque deuxième transistor d'accès un courant de fuite (courant drain-source) supérieur, de préférence au moins dix fois supérieur, au courant de fuite de chaque autre transistor de la cellule de mémoire statique MCH.

Sur les figures 4 à 7, on a représenté, à des fins de simplification, uniquement les transistors de mémorisation et les deuxièmes transistors d'accès. Les premiers transistors d'accès T9 et T10 n'ont pas été représentés sur ces figures.

Sur la figure 4, on a représenté les transistors d'accès TA1 et TA2 dans leur état bloqué avec le signal logique DCD à l'état haut (tension Vdd sur les grilles G1 et G2 de ces transistors d'accès). Par ailleurs, les sources S1 et S2, connectées aux lignes d'entrée-sortie ION et IO, sont portées à la tension Vdd.

Les références B3 et B4 désignent les substrats ("bulk" en langue anglaise) des transistors de mémorisation TM3 et TM4. Ces substrats B3 et B4 sont classiquement reliés aux sources respectives de ces transistors, et par conséquent à la masse. De même, les substrats des premiers transistors d'accès PMOS, T9 et T10 sont également reliés classiquement à leur source.

Par contre, on applique un effet substrat aux transistors PMOS, TA1 et TA2, en polarisant les substrats B 1 et B2 de ces transistors avec une tension VR inférieure à la tension de source qui est en l'espèce la tension Vdd appliquée sur les lignes d'entrée-sortie IO et ION.

Cette tension VR est obtenue par exemple par une source de tension régulée REG, délivrant à partir de la tension Vdd une tension régulée VR égale par exemple à Vdd - 0,15 volt. Cette source de tension régulée peut être obtenue à partir d'une diode Zener dont la tension de seuil est convenablement choisie.

D'une façon plus générale, on choisira de préférence pour la différence de tension entre la source et le substrat du transistor d'accès TA1 ou TA2, une différence de tension inférieure à la tension de seuil du transistor, par exemple une tension de l'ordre de 0,15 à 0,3 volt. Ces ordres de grandeur permettent d'obtenir un courant de fuite pour les transistors TA1 et TA2 légèrement plus que dix fois supérieur au courant de fuite des autres transistors de la cellule de mémoire statique, ce qui a été jugé acceptable à certaines applications pour une bonne rétention de la donnée mémorisée dans la cellule de mémoire statique.

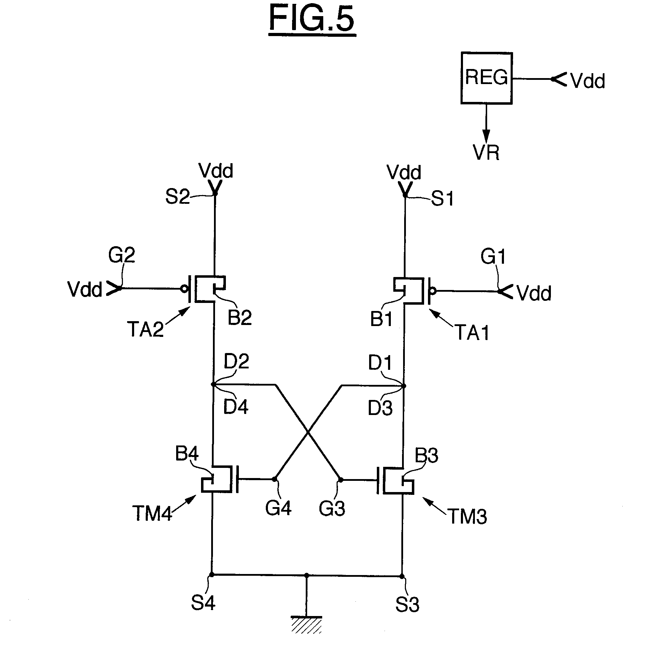

En variante, comme illustré sur la figure 5, on peut, alors que le substrat et la source de chaque transistor d'accès TA1 et TA2 sont reliés ensemble, rendre légèrement conducteur chacun de ces transistors d'accès TA1 et TA2 et en particulier dans le cas présent le transistor TA2, en appliquant une tension VR sur la grille, inférieure à la tension présente sur les lignes d'entrée-sortie, c'est-à-dire la tension appliquée aux sources S 1 et S2. Là encore, cette différence de tension grille-source reste bien inférieure à la tension de seuil du transistor, de façon à le maintenir néanmoins dans un état bloqué.

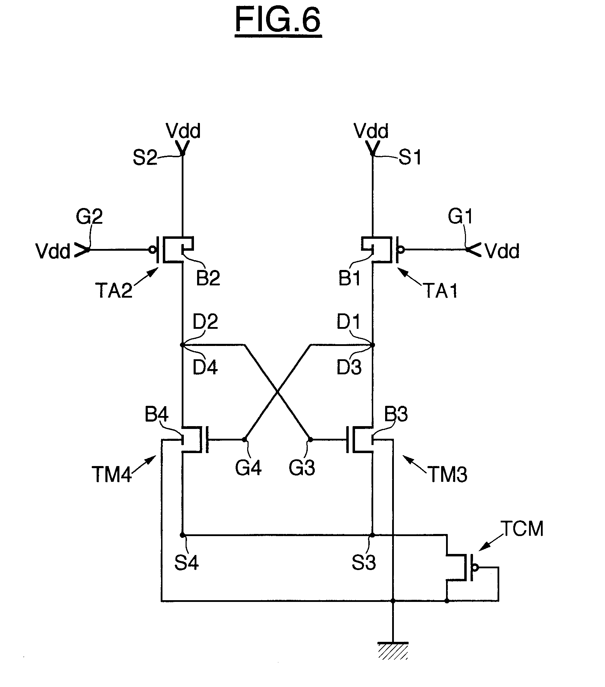

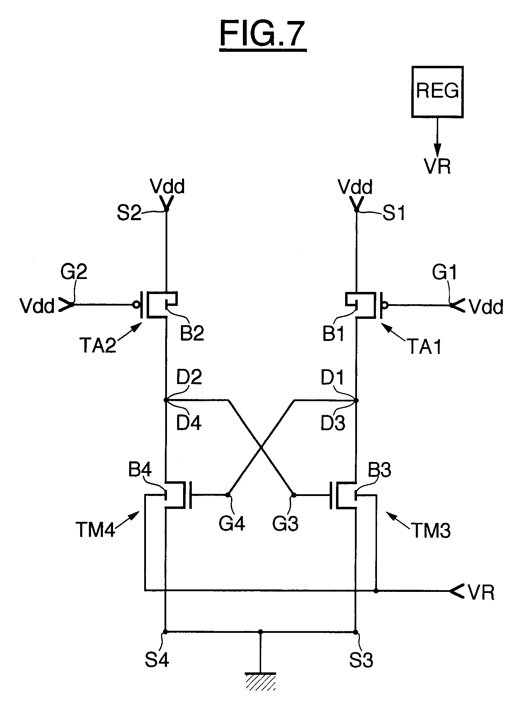

Alors que dans les variantes illustrées sur les figures 4 et 5, on a agi sur les deuxièmes transistors d'accès TA1 et TA2 pour les rendre plus "fuiteux", les variantes illustrées sur les figures 6 et 7 prévoient cette fois-ci d'agir sur les autres transistors de la cellule de mémoire statique, en l'espèce les transistors de mémorisation TM3 et TM4 ainsi que les premiers transistors d'accès T9 et T10, de façon à les rendre moins "fuiteux" et par conséquent de façon à rendre les deuxièmes transistors TA2 et TA1 plus "fuiteux".

Plus précisément, dans les variantes illustrées sur les figures 6 et 7, les moyens de rétention comportent des moyens aptes à appliquer un effet substrat sur chaque transistor de la cellule statique (en l'espèce les transistors de mémorisation TM3 et TM4 et les premiers transistors d'accès T9 et T10) à l'exception des deuxièmes transistors d'accès TA2 et TA1, de façon à obtenir un courant de fuite de chaque deuxième transistor d'accès supérieur, de préférence au moins dix fois supérieur, au courant de fuite de chaque autre transistor de la cellule de mémoire statique.

Dans la variante illustrée sur la figure 6, les prises de substrat B 1 et B2 des deux transistors d'accès TA2 et TA1 sont reliées à leur source. Par contre, les sources des transistors de mémorisation TM3 et TM4 sont polarisées avec une tension supérieure à leur tension de substrat qui est en l'espèce la masse.

Dans le cas présent, les moyens qui permettent de polariser la source avec une tension supérieure à celle du substrat, comportent un transistor PMOS TCM qui est toujours passant. Ainsi, la tension de source est égale à la tension de seuil du transistor TCM, c'est-à-dire en l'espèce environ 0,5 volt. De par cet effet substrat, on augmente la tension de seuil des transistors de mémorisation et par conséquent, on diminue le courant de fuite de ces transistors. Une différence de tension entre la source et le substrat de l'ordre de 0,5 volt permet d'obtenir, pour une technologie de 0,25 micron, un rapport supérieur à 10, mais pas trop grand, entre le courant de fuite des deuxièmes transistors d'accès TA2 et TA1 et les courants de fuite des transistors de mémorisation, tout en gardant une dynamique acceptable pour la cellule-mémoire.

Bien entendu, ce qui est décrit ici pour les transistors de mémorisation TM3 et TM4 est également valable pour les premiers transistors d'accès PMOS T9 et T10 (figure 2). Cependant, dans ce cas, on appliquera sur les substrats de ces transistors T9 et T10 une tension de substrat supérieure à la tension de source de ces transistors, par exemple une tension de substrat égale à Vdd + 1 volt obtenue par exemple par une pompe de charge.

Sur la figure 7, l'effet substrat appliqué aux transistors de mémorisation TM3 et TM4 est obtenu en reliant cette fois-ci leur source à la masse et en appliquant sur les substrats B3 et B4 une tension prédéterminée VR négative, par exemple de l'ordre de -1 volt. Les moyens REG qui permettent d'appliquer cette tension VR, peuvent par exemple comporter une pompe de charge négative de structure classique et bien connue de l'homme du métier.

Bien entendu, une telle variante est applicable avec une technologie dite "triple caisson", bien connue de l'homme du métier. On rappelle ici que dans une technologie tripe caisson, les transistors NMOS sont réalisés au sein d'un caisson P isolé latéralement du substrat du circuit intégré (plaquette) par un caisson N. Il est ainsi aisément possible d'appliquer une tension de substrat négative sur la prise de contact du transistor NMOS sans pour cela polariser de la même façon le substrat général de la plaquette.

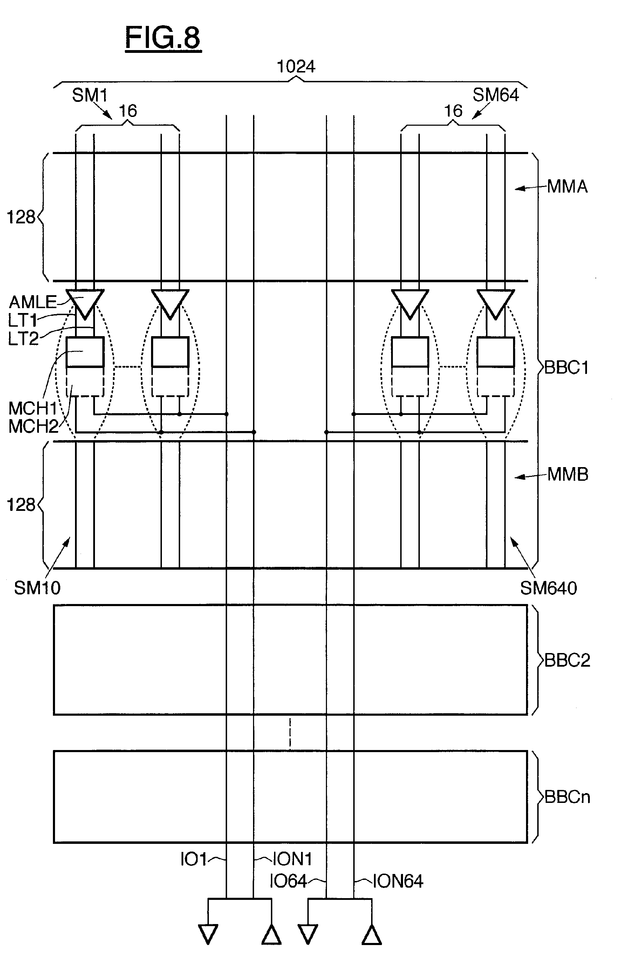

Sur la figure 8, on a représenté schématiquement une architecture globale d'un dispositif de mémoire vive dynamique selon l'invention.

Sur cette figure, un groupe de 16 colonnes et de 128 rangées forme une sous-matrice de cellules-mémoire. Si la mémoire comporte 1024 colonnes, on obtient donc 64 sous-matrices SM1-SM64. Chaque sous-matrice est associée alors à une paire de lignes d'entrée-sortie (IO1; ION1), (IO64; ION64). Chaque sous-matrice est associée à des paires de lignes d'entrée-sortie différentes. Et tous les étages de mémoire-cache associés à une sous-matrice sont tous connectés en parallèle à la paire de lignes d'entrée/sortie associée à cette sous-matrice.

Par ailleurs, dans l'exemple illustré sur la figure 8, deux étages de mémoire-cache MCH1, MCH2 sont respectivement connectés en parallèle à chaque amplificateur de lecture-écriture AMLE.

Les 64 sous-matrices SM1-SM64 de 16 colonnes forment une matrice de cellules-mémoire MMA.

Un bloc-mémoire BBC1 du plan-mémoire comporte alors une deuxième matrice MMB structurellement analogue à la première matrice MMA et composée également de 64 sous-matrices SM10-SM640. Les amplificateurs AMLE, les étages de mémoire-cache MCH1, MCH2 et les paires de lignes d'entrée-sortie (IO1; ION1 ), ..., (IO64; ION64) sont communs aux deux matrices MMA et MMB. Ces deux matrices sont connectées de façon identique en parallèle aux amplificateurs, étages de mémoire-cache et paires de lignes d'entrée-sortie. Le plan-mémoire comporte plusieurs blocs-mémoire, par exemple quatre, BBC1, BBC2 ,..., BBCn. Les paires de lignes d'entrée-sortie sont alors communes aux différents blocs-mémoire.

L'homme du métier aura noté que les deuxièmes transistors d'accès TA1 et TA2 participent au décodage de colonnes. Par ailleurs, avec une telle architecture, on peut extraire successivement avec une même paire de lignes d'entrée-sortie, 16 informations contenues dans 16 cellules-mémoire. Par ailleurs, on peut, en activant simultanément les 64 paires de lignes d'entrée-sortie, obtenir simultanément en sortie 64 informations. Ce qui est possible horizontalement l'est également verticalement, en sélectionnant des colonnes situées dans des sous-matrices différentes et raccordées à la même paire de lignes d'entrée-sortie.

Le dispositif de mémoire selon l'invention permet donc d'extraire les informations mémorisées par "salve" (burst", en langue anglaise) "bidimensionnelle", ce qui est particulièrement intéressant dans des applications vidéo notamment. En effet, la latence est ainsi supprimée aussi bien dans le sens horizontal que dans le sens vertical, ce qui permet dans des applications graphiques d'effectuer des traitements identiques pour un mouvement latéral ou un mouvement vertical de l'image.

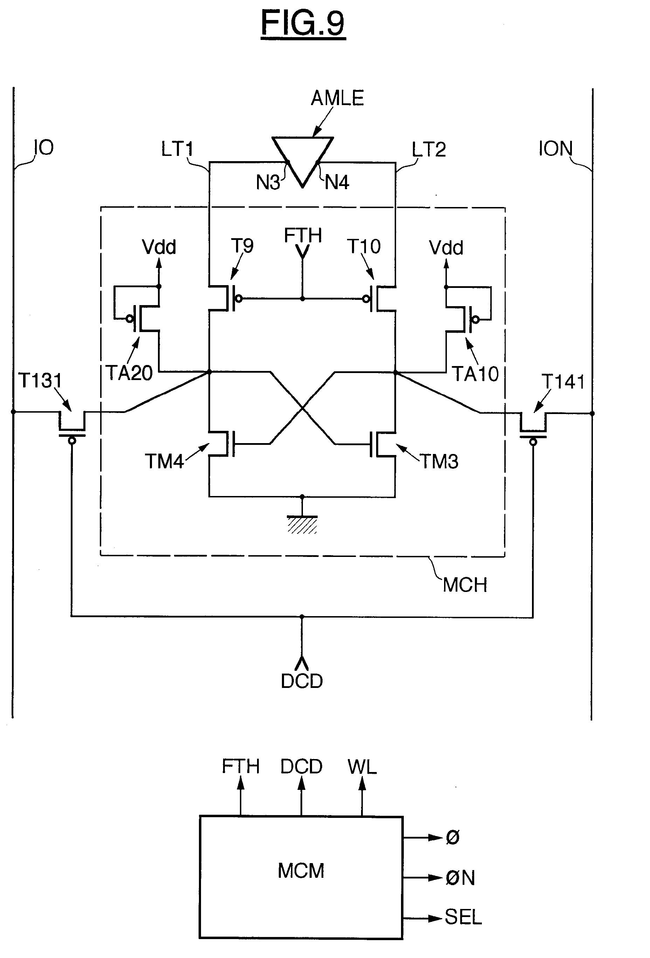

La figure 9 illustre une autre variante de réalisation d'un étage de mémoire-cache selon l'invention. On ne décrira ici à des fins de simplification que les différences entre cette variante et la variante qui vient d'être décrite en référence à la figure 2.

Outre les deuxièmes transistors d'accès T131 et T141 qui relient les transistors de mémorisation aux lignes d'entrée-sortie IO et ION, la cellule de mémoire statique comporte une paire de transistors auxiliaires constamment bloqués et respectivement connectés entre les transistors de mémorisation et une source de tension prédéterminée.

En l'espèce, les transistors TA10 et TA20 sont des transistors PMOS dont les grilles et sources sont reliées ensemble à la tension d'alimentation Vdd. Ce sont cette fois-ci ces transistors auxiliaires qui présentent des courants de fuite plus importants que les autres transistors de la cellule de mémoire statique.

En d'autres termes, les transistors auxiliaires TA10 et TA20 doivent présenter des courants de fuite plus importants que les transistors de mémorisation TM4 et TM3, que les premiers transistors d'accès T9 et T10, et que les deuxièmes transistors d'accès T131 et T141. Les moyens de rétention comportent donc ici ces transistors auxiliaires.

Bien entendu, les différentes possibilités qui ont été décrites ci-avant pour conférer aux transistors d'accès TA1 et TA2 des courants de fuite plus importants, s'appliquent ici aux transistors auxiliaires.

Par rapport à la variante illustrée sur la figure 2, cette cellule de mémoire statique présente un encombrement légèrement plus important en raison de la présence de deux transistors auxiliaires supplémentaires. Cependant, elle offre la possibilité d'appliquer sur les lignes d'entrée/sortie IO et ION une tension de mode commun quelconque.

Bien entendu, tout ce qui vient d'être décrit s'applique également à un dispositif dont les transistors PMOS seraient des transistors NMOS et inversement. L'homme du métier saura effectuer les modifications nécessires. A titre indicatif, la tension Vdd devra être remplacée par la masse et inversement. De même, les effets substrat obtenus par exemple par des substrats portés à une tension d'alimentation Vdd diminuée de quelques millivolts pour des transistors PMOS, devront être portés à une tension de quelques millivolts au lieu de la masse pour les transistors NMOS et inversement.

## Revendications

1. Dispositif de mémoire vive dynamique, comprenant un plan mémoire comportant au moins une première matrice (NMA) de cellules-mémoire (CM), un amplificateur de lecture/écriture (AMLE) connecté à l'extrémité de chaque colonne de la matrice et au moins une paire de lignes d'entrée/sortie (IO, ION) associée à la matrice, caractérisé par le fait qu'il comprend en outre au moins un étage de mémoire-cache (MCH) connecté à chaque amplificateur et disposé au voisinage immédiat de cet amplificateur, cet étage de mémoire-cache comportant une cellule de mémoire vive statique connectée entre l'amplificateur de lecture/écriture (AMLE) et la paire de lignes d'entrée/sortie (IO, ION).

2. Dispositif selon la revendication 1, caractérisé par le fait que la cellule de mémoire vive statique possède deux transistors de mémorisation (TM3, TM4), une paire de premiers transistors d'accès (T9, T10) connectés entre l'amplificateur et les transistors de mémorisation, une paire de deuxièmes transistors d'accès (TA1, TA2) respectivement connectés entre la paire de lignes d'entrée/sortie et les transistors de mémorisation et par le fait que l'étage de mémoire-cache comporte des moyens de rétention (TA1, TA2) aptes à maintenir dans ladite cellule de mémoire statique une donnée binaire y ayant été préalablement transférée depuis une cellule-mémoire via l'amplificateur.

3. Dispositif selon la revendication 2, caractérisé par le fait que les deuxièmes transistors d'accès (TA1, TA2) ont des courants de fuite plus importants que les autres transistors de la cellule de mémoire statique, et par le fait que les moyens de rétention comportent les deuxièmes transistors d'accès.

4. Dispositif selon la revendication 2, caractérisé par le fait que la cellule de mémoire statique comporte une paire de transistors auxiliaires (TA 10, TA20) constamment bloqués et respectivement connectés entre les transistors de mémorisation et une source de tension prédéterminée (Vdd), par le fait que les transistors auxiliaires ont des courants de fuite plus importants que les autres transistors de la cellule de mémoire statique, et par le fait que les moyens de rétention comportent les transistors auxiliaires.

5. Dispositif selon l'une des revendications 2 à 4, caractérisé par le fait que les deuxièmes transistors d'accès (TA1, TA2) ou les transistors auxiliaires (TA10, TA20) ont une longueur de canal et une épaisseur d'oxyde de grille plus petite que la longueur de canal et l'épaisseur d'oxyde de grille des autres transistors de la cellule de mémoire statique.

6. Dispostif selon l'une des revendications 2 à 5, caractérisé par le fait que les moyens de rétention comportent des moyens (REG) aptes à appliquer un effet substrat sur chaque transistor de la cellule de mémoire statique à l'exception des deuxièmes transistors d'accès ou des transistors auxiliaires de façon à obtenir un courant de fuite de chaque transistor auxiliaire ou de chaque deuxième transistor d'accès supérieur, de préférence au moins dix fois supérieur, au courant de fuite de chaque autre transistor de la cellule de mémoire statique.

7. Dispositif selon l'une des revendications 2 à 5, caractérisé par le fait que les moyens de rétention comportent des moyens aptes à appliquer des tensions de polarisation prédéterminées différentes en certaines des bornes de chaque deuxième transistor d'accès ou de chaque transistor auxiliaire de façon à faire circuler dans chaque deuxième transistor d'accès ou dans chaque transistor auxiliaire un courant drain-source supérieur, de préférence au moins dix fois supérieur, au courant de fuite de chaque autre transistor de la cellule de mémoire statique.

8. Dispositif selon l'une des revendications précédentes, caractérisé par le fait que la matrice (MMA) de cellules-mémoire comporte plusieurs sous-matrices (SM1-SM64) respectivement associées à des paires de lignes d'entrée/sortie différentes, tous les étages de mémoire-cache associés à une sous-matrice étant tous connectés en parallèle à la paire de lignes d'entrée/sortie associée à cette sous-matrice.

9. Dispositif selon la revendication 8, caractérisé par le fait que le plan mémoire comporte un bloc-mémoire (BBC1) formé de la première matrice (MMA) de cellules-mémoires et d'une deuxième matrice (MMB) de cellules-mémoire, par le fait que les amplificateurs, les étages de mémoire-cache et les paires de lignes d'entrée/sortie étant communs aux deux matrices, les deux matrices étant connectées de façon identique en parallèle aux amplificateurs, étages de mémoire-cache et paires de lignes d'entrée/sortie.

10. Dispositif selon la revendication 9, caractérisé par le fait que la plan mémoire comporte plusieurs blocs-mémoire (BBC1-BBCn), les paires de lignes d'entrée/sortie étant communes aux différents blocs-mémoire.

11. Dispositif selon l'une des revendications précédentes, caractérisé par le fait qu'il comprend au moins deux étages de mémoire-cache (MCH1, MCH2) respectivement connectés en parallèle à chaque amplificateur.

12. Procédé de lecture d'une donnée mémorisée dans une cellule-mémoire du plan mémoire du dispositif de mémoire tel que défini dans l'une des revendications 1 à 11, caractérisé par le fait qu'on transfert la donnée dans la cellule de mémoire vive statique de l'étage de mémoire-cache (MCH) associé à la colonne contenant ladite cellule-mémoire, puis on lit le contenu de la cellule de mémoire statique par l'intermédiaire des lignes d'entrée/sortie.
